(19) Europäisches Patentamt
European Patent Office
Office européen des brevets

(11) Numéro de publication: **0 221 793**
**B1**

# (12) FASCICULE DE BREVET EUROPEEN

(45) Date de publication du fascicule du brevet: **28.11.90**

(51) Int. Cl.[5]: **C08L 79/02**, C08G 73/02, H01B 1/12, C09K 9/02

(21) Numéro de dépôt: **86402105.0**

(22) Date de dépôt: **25.09.86**

(54) **Polymères conducteurs électroniques azotés, leurs procédés de préparation, cellule d'affichage électrochrome et générateur électrochimique utilisant ces polymères.**

(30) Priorité: **30.09.85 FR 8514451**

(43) Date de publication de la demande: **13.05.87 Bulletin 87/20**

(45) Mention de la délivrance du brevet: **28.11.90 Bulletin 90/48**

(84) Etats contractants désignés: **DE GB NL SE**

(56) Documents cités: **EP-A- 0 062 837**

**Le dossier contient des informations techniques présentées postérieurement au dépôt de la demande et ne figurant pas dans le présent fascicule.**

(73) Titulaire: **COMMISSARIAT A L'ENERGIE ATOMIQUE, 31/33, rue de la Fédération, F-75015 Paris(FR)**

(72) Inventeur: **Genies, Eugène, Rue Troussai, F-38120 Saint Egreve(FR)**

(74) Mandataire: **Mongrédien, André et al, c/o BREVATOME 25, rue de Ponthieu, F-75008 Paris(FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).



ACTORUM AG

## Description

La présente invention a pour objet de nouveaux polymères conducteurs électroniques azotés et leurs procédés de préparation. Ces polymères sont parfaitement bien adaptés pour constituer la couche électrochrome d'une cellule d'affichage électrochrome ainsi que pour constituer la matière active d'électrode d'un générateur électrochimique.

Outre ces applications spécifiques, les polymères conducteurs de l'invention peuvent être utilisés comme composants pour des éléments de circuits électroniques passifs ou actifs, comme blindage électromagnétique, comme matériau servant à éliminer les charges électro-statiques, comme matrice ou liant entrant dans la composition des matériaux composites, comme convertisseur voltaïque et comme matériau d'électrode à propriétés spécifiques.

En tant que matériau d'électrode, les polymères selon l'invention peuvent être utilisés dans les piles à combustible, en chimie analytique, en catalyse chimique et électrochimique, pour la détermination du potentiel ou du pH d'une solution pour la protection contre la corrosion.

Les polymères de l'invention peuvent aussi être utilisés comme détecteur de gaz, d'eau, de radiation, ou comme écran antiradar ou encore comme porte ionique.

En résumé, les polymères conducteurs électroniques selon l'invention peuvent être utilisés dans tous les domaines employant généralement des matériaux conducteurs.

Parmi les polymères conducteurs électroniques connus, deux types de matériaux se distinguent particulièrement. Le premier type est relatif au polyacétylène et ses dérivés et le second type à la polyaniline et ses dérivés.

L'utilisation du polyacéthylène comme matière active d'électrode ou comme matériau électrochrome est notamment décrite dans les documents EP-A 0 036 118 et Journal de Physique, Colloque C3, supplément au n° 6, tome 44, juin 1983 de M. Gazard et al., "Electrooptical properties of thin films of polyheterocycles", p. 537–542.

Les propriétés et l'utilisation de la polyaniline comme matériau électrochrome et comme matière active d'électrode sont données dans les documents J. Electroanal. Chem. 195 (1985), p. 109–128, de E.M. Genies et C. Tsintavis, "Redox mechanism and electrochemical behaviour of polyaniline deposits" et FR-A 2 577 937.

Le polyacétylène, de formule globale $(CH)_x$, existe sous trois formes, une forme (I) non dopée, neutre, une forme (II) oxydée, dopée p, et une forme (III) réduite, dopée n.

Ces formes peuvent être respectivement symbolisées par les chaînes suivantes :

(I) $-CH=CH-CH=CH-CH=CH-CH=CH-$

(II) $=CH-CH=CH-CH-\overset{\oplus}{C}H=CH-CH=CH- \quad + X^-$

(III) $=CH-CH=CH-CH-\overset{\ominus}{C}H=CH-CH=CH- \quad + Y^+$

formules dans lesquelles $X^-$ et $Y^+$ représentent respectivement un anion et un cation simple ou complexe. Comme anion, on peut citer $ClO^-_4$, $Cl^-$, $Br^-$, $I^-_3$, $FSO^-_3$, $SO_4^{2-}$, $BF^-_4$, $PF^-$, etc... et comme cation, $Li^+$, $Na^+$, $K^+$ etc...

Le polyacétylène se distingue par le fait que sa structure est constituée d'une succession de simple et de double liaisons carbone-carbone. Du fait de sa structure relativement simple, en partie cristalline, et de ses propriétés électro-actives (conductivité électrique de 1000 $ohms^{-1}cm^{-1}$) donnant lieu à de nombreuses applications, le polyacétylène a soulevé un intérêt considérable. Malheureusement ce matériau est beaucoup trop instable et réactif pour espérer obtenir des exemples d'application durables dans le temps.

La polyaniline qui soulève aussi un grand intérêt du fait de sa grande stabilité se distingue par le fait qu'elle peut subir deux types de transferts de charges.

Elle se présente sous un grand nombre de formes et en particulier sous une forme réduite (1) iso lante, sous une première forme oxydée (2) isolante,et conductrice lorsqu'elle est protonnée, et une seconde forme oxydée (3) aussi conductrice. Ces trois formes existent en milieu neutre ou basique. En milieu acide, il existe d'autres formes protonées dont nous ne parlerons pas ici.

Les trois formes (1), (2) et (3) sont symbolisées respectivement par les chaînes :

(1) 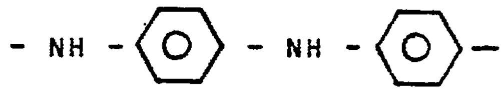

(2) 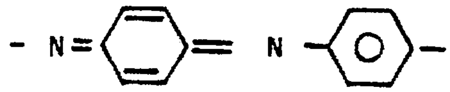

(3) 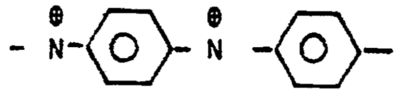 + 2 $X^-$

formules dans lesquelles $X^-$ représente un anion simple ou complexe. Comme anion on peut citer $ClO^-_4$, $SO_4^{2-}$, $Cl^-$, $F^-$, $Br^-$, $I^-$, $I^-_3$, $BF^-_4$, $PF^-_6$, $FSO^-_3$.

La forme (2) est obtenue par oxydation de la forme (1) entraînant le départ d'un électron et d'un $H^+$ par atome d'azote. De même, la forme (3) est obtenue par oxydation de la forme (1) conduisant au départ d'un électron par atome d'azote. Cette forme (3) doit en réalité se nommer polynitrénium de phénylène.

La polyaniline se trouve être un polymère conducteur doué d'une très forte capacité massique. Expérimentalement, la capacité massique mesurée est voisine de 150 Ah/kg. Malheureusement sa conductivité électrique de 1 à 10 $ohms^{-1}cm^{-1}$ est relativement faible, ce qui limite ses applications.

La présente invention a justement pour objet de nouveaux polymères conducteurs électroniques azotés alliant les propriétés du polyacétylène et de la polyaniline. En particulier, ces polymères sont doués d'une forte capacité massique, d'une très bonne conductivité electrique. Par ailleurs, ces polymères sont stables et peu réactifs, ce qui permet de les utiliser dans un grand nombre d'exemples d'applications durables dans le temps.

De façon plus précise, l'invention a pour objet un polymère conducteur électronique azoté, caractérisé en ce qu'il présente sous forme réduite A la formule :

$$-[-NH-(-CH=CH-)_{\overline{n}}-]_{\overline{x}} \quad ,$$

sous une première forme oxydée B la formule:

$$-[-N=(=CH-CH=)=_n N-(-CH=CH-)_{\overline{n}}-]_{\overline{y}} \quad ,$$

et sous une seconde forme oxydée C la formule:

$$-[-\overset{\oplus}{N}-(-CH=CH-)-n-]-X^-,$$

formules dans lesquelles n, x et y sont des entiers tels que $1 \leqq n \leqq 20$, $10 \leqq x \leqq 1\,000\,000$ et $5 \leqq y \leqq 500\,000$, $X^-$ représente un anion simple ou complexe. Tout ou partie des hydrogènes portés par les carbones du polymère est éventuellement substitué.

Dans la suite de la description, les carbones appartenant à la chaîne $-(-CH=CH-)_{\overline{n}}$ ou $=(=CH-CH=)=_n$ des formes A, B et C des polymères de l'invention seront appelés "carbones acétyléniques".

La forme A correspond à une polyamine d'acétylènes, la forme B à une polyimine d'acétylènes et la forme C a un polynitrénium d'acétylènes. On passe de la forme A à la forme B (départ d'un $e^-$ et d'un $H^+$ par N) puis à la forme C (départ d'un $e^-$ par N) par oxydations successives. Inversement, on passe de la forme C à la forme B puis à la forme A par réductions successives.

La composition exacte de ces polymères conducteurs dépend des applications envisagées. En particulier, l'adjonction de façon avantageuse d'un reste oxydoréducteur et/ou photosensible permet d'utiliser les polymères conducteurs de l'invention comme matériau d'électrode ou comme convertisseur photovoltaïque.

Comme reste oxydoréducteur,on peut utiliser un grand nombre de complexes de métaux de transition tels que le ferrocène ou les viologènes. Comme reste photosensible, on peut utiliser une quinone, une anthraquinone et leurs dérivés.

D'autres complexes de métaux de transition tels que les porphyrines, les phtalocyanines, l'hémoglobine, la chlorophylle et leurs dérivés, offrant à la fois des propriétés oxydoréductrices et photosensibles, peuvent être utilisés.

De préférence, les hydrogènes portés par les "carbones acétyléniques" des polymères selon l'invention sont substitués en tout ou partie par un halogène, un radical alkyle, linéaire ou ramifié, ou un radical aryle, éventuellement substitué, un groupement choisi parmi :

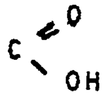, 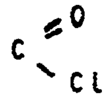, 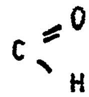, 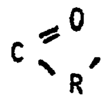, 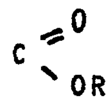, 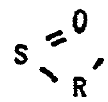, 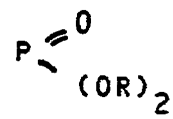,

$SO_2R$, SR, OR, avec R un radical alkyle, linéaire ou ramifié, ou un radical aryle, éventuellement substitué, et parmi OH, $NO_2$, $NH_2$, $CF_3$, $SO_2$, CN, SCN, OCN.

Comme halogène, on peut utiliser le fluor, le brome, le chlore ou l'iode.

Les radicaux alkyle substituant tout ou partie des hydrogènes portés par les carbones acétyléniques des polymères et le radical alkyle R des substituants de ces hydrogènes comportent 1 à 100 atomes de carbone. Les radicaux alkyle utilisables sont par exem ple les radicaux méthyle, éthyle, n-propyle, isopropyle, n-butyle, isobutyl, n-pentyl.

Eventuellement les radicaux alkyle substituant des hydrogènes portés par les carbones acétyléniques des polymères peuvent être substitués en partie ou en totalité par un groupement choisi parmi :

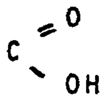, 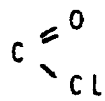, 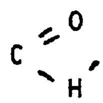, 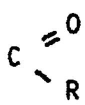, 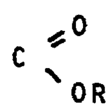, 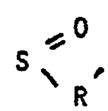, 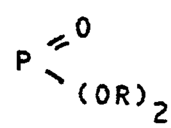,

$SO_2R$, SR, OR, avec R un radical alkyle, linéaire ou ramifié, ou un radical aryle, éventuellement substitué, et parmi OH, $NO_2$, $NH_2$, $CF_3$, $SO_2$, CN, SCN, OCN.

De même, comme radicaux aryle substituant tout ou partie des hydrogènes portés par lescarbones acétyléniques des polymères et comme radical aryle R des substituants de ces hydrogènes utilisables, on peut citer les radicaux benzénique, naphtalénique, anthracénique.

Eventuellement les radicaux aryle substituant des hydrogènes portés par les carbones acétyléniques peuvent être substitués. Comme substituant on peut utiliser les mêmes que çeux des radicaux alkyle substitués.

De façon préférentielle, lorsque le polymère selon l'invention est sous forme de polynitrénium d'acétylènes ou sous forme de polyimine d'acétylènes protonnée, l'anion $X^-$ peut être par exemple $Cl^-$, $HSO^-_4$, $BF^-_4$, $SO_3F^-$, $BR^-$, $F^-$, $I^-$, $ClO^-_4$, $H_2PO^-_4$, $SO_4^{2-}$, $PF^-_6$, $S^{2-}$, $(S_p)^{2-}$ avec $1 \leqq p \leqq 10$, ou un polyanion tel que le Nafion®.

Le polymère conducteur électronique selon l'invention correspondant à n=1 est la polyamine de vinyle (PVA), qui présente sous forme réduite A la formule :

$$-[-NH-CH=CH-]-_x \quad ,$$

sous la première forme oxydée B la formule :

$$-[-N=CH-CH=N-CH=CH-]-_{x/2}$$

et sous la seconde forme oxydée C la formule :

$$-(-\overset{\oplus}{N}-CH=CH-)-_x X^-.$$

L'anion $X^-$ peut être l'un de ceux cités précédemment.

En particulier, x peut varier entre 10 et 1 000 000 et par exemple 100.

Il ne faut pas confondre la polyamine de vinyle, polymère selon l'invention, avec la polyvinylamine de formule $-[-C(NH_2)=CH-]-_z$ analogue au polychlorure de vinyle (PVC), z étant un nombre entier.

Un autre polymère conducteur électronique selon l'invention, de structure relativement simple correspondant à n=2, est la polyamine de butadiène qui présente sous forme réduite A la formule :

$$-[-NH-CH=CH-CH=CH-]-_x \, ,$$

sous la première forme oxydée B la formule :

$$-[-N=CH-CH=CH-CH=N-CH=CH-CH=CH-]-_{x/2}$$

et sous la seconde forme oxydée C la formule :

$$-[-\overset{\oplus}{N}-CH=CH-CH=CH-]-_x X^-.$$

En particulier, x peut varier entre 10 et 50 000 et par exemple 50. L'anion $X^-$ peut être un de ceux déjà cités.

Un autre polymère conducteur selon l'invention est la polyamine d'hexatriène, correspondant à n=3, présentant sous forme réduite A la formule :

$$-[-NH-CH=CH-CH=CH-CH=CH-]-_x ,$$

sous la première forme oxydée B la formule :

$$-[-N=CH-CH=CH-CH=CH-CH=N-CH=CH-CH=CH-CH=CH-]-_{x/2}$$

et sous la troisième forme oxydée C la formule :

$$-[-\overset{\oplus}{N}-CH=CH-CH=CH-CH=CH-]-_x X^-.$$

x peut varier entre 2 et 20 000 et par exemple 20. L'anion $X^-$ est par exemple un de ceux donnés ci-dessus.

Il ressort des trois composés polymériques ci-dessus que la structure des polymères conducteurs électroniques azotés selon l'invention est constituée d'une succession de simple et de double liaisons carbone-carbone, comme le polyacétylène. C'est l'existence de ces doubles liaisons carbone-carbone qui confère aux polymères conducteurs selon l'invention une conductivité électrique supérieure à celle des polyanilines. Inversement, la présence d'atomes d'azote interrompant la chaîne carbonée des polymères assure à ceux-ci une bonne stabilité.

L'invention a aussi pour objet un premier procédé de préparation d'un polymère conducteur électronique azoté tel que décrit précédemment.

Ce premier procédé se caractérise en ce que l'on oxyde en milieu liquide un monomère de formule $NH_2-(-CH=CH-)-_nH$, n étant un entier tel que $1 \leq n \leq 20$, formule dans laquelle tout ou partie des hydrogènes portés par les carbones est éventuellement substitué.

Il permet d'obtenir les polymères selon l'invention sous leur forme oxydée C.

Les substituants éventuels des hydrogènes portés par les carbones acétyléniques du monomère à oxyder sont en particulier ceux décrits précédemment lors de la définition des polymères selon l'invention.

L'oxydation en milieu liquide se fait de préférence dans un milieu fortement acide, c'est-à-dire dans un milieu contenant un acide ou un mélange d'acide dont l'équivalent pH est avantageusement inférieur à 0 par référence à l'eau, comme par exemple l'acide sulfurique, l'acide phosphorique, l'acide fluorhydrique, l'acide benzène sulfonique, l'acide chlorhydrique, l'acide tétrafluoroborique, l'acide hexafluorophos phorique, l'acide fluorosulfurique ou chlorosulfurique.

Pour les polymères selon l'invention correspondant à n égale à 1, c'est-à-dire la vinylamine, monomère de formule $NH_2-(-CH=CH-)-H$, et ses dérivés simples, peuvent être formés par oxydation de l'amine saturée correspondante en milieu liquide notamment fortement acide. En particulier, la polyamine de vinyle (PVA) peut être formée directement à partir de l'éthylamine, car au cours du processus d'oxydation, celle-ci sera d'abord oxydée en vinylamine.

L'oxydation en milieu liquide notamment acide selon l'invention se fait avantageusement dans un milieu riche en fluorures. En particulier, on peut utiliser des mélanges $RNH_2$, HF avec R représentant un radical alkyl, des mélanges de pyridine, HF ou des mélanges $NH_4F$, $\alpha$HF, avec $\alpha$ allant de 1 à 4. En particulier $\alpha$ vaut 2,35 ce qui correspond à l'eutectique $NH_3$, HF qui contient environ 54,2% de HF libre et 80,9% de HF total (en poids). Cette solution eutectique sera appelée par la suite bain "N".

Il est possible de remplacer le milieu acide riche en fluorures par un autre milieu acide. Les acides utilisables sont ceux donnés précédemment. Par ail leurs, l'oxydation peut aussi avoir lieu dans un solvant organique tel que l'acétonitrile, le nitrométhane, le nitrobenzène, le benzonitrile, ou des solutions de polyanions tels que le Nafion®.

L'oxydation de l'amine d'acétylènes (monomère de formule $NH_2-(-CH=CH-)-_nH$ avec $1 \leq n \leq 20$) en milieu liquide peut être réalisée soit chimiquement soit électrochimiquement. La voie chimique fait intervenir des agents oxydants tels que le bichromate de potassium, le permanganate de potassium, l'eau oxygénée et autres péroxydes, le tétroxyde d'osmium, le persulfate d'ammonium, dissous ou en suspension dans le milieu liquide ci-dessus.

Par voie électrochimique, les polymères selon l'invention sont déposés électrolytiquement sur un support tel que le platine, le nickel, le Monel (alliage Ni-Cu), le carbone ou tout autre support en matériau revêtu de carbone comme par exemple un support en acier inxoydable revêtu d'une peinture au graphite. Les densités de courant utilisées pour ce dépôt électrochimique varient entre 0,05 et 100 $mA/cm^2$. Les solvants peuvent être les mêmes que ci-dessus, en présence de sels tels que $LiClO_4$, $LiBF_4$, $LiPF_6$. Il peut s'agir également de solutions de Nafion®. On peut utiliser également un support conducteur recouvert de polymères classiques tels que les polyesters, les polyamides, pour obtenir un matériau composite.

Cette technique d'oxydation des polymères selon l'invention, lorsqu'on envisage de les utiliser comme matériau actif d'électrode dans un générateur électrochimique ou batterie, permet d'obtenir directement l'électrode de ce générateur.

Les polymères conducteurs selon l'invention préparés par le procédé décrit ci-dessus possèdent des propriétés électrochimiques très supérieures à un grand nombre d'autres polymères conjugués conducteurs connus. Ainsi, après 1600 cycles de charge et de décharge complètes, la batterie à base des polymères selon l'invention, conserve encore 80% de sa capacité alors que d'autres polymères, le polypyrrole ou le polyacétylène par exemple perdent 20% de leur capacité après 100 cycles.

Le procédé de préparation décrit précédemment a notamment été décrit pour préparer des polyanilines dans le document FR-A-2 545 494 publié le 9 novembre 1984.

Les polymères conducteurs électroniques selon l'invention peuvent être obtenus au moyen d'un second procédé de préparation.

Ce second procédé se caractérise en ce que l'on fait réagir dans un solvant organique un métal alcalin ou alcalinoterreux sur un composé de formule $NH_2-(-CH=CH-)_nZ$, n étant un entier tel que $1 \leq n \leq 20$ et Z étant un halogène, formule dans laquelle tout ou partie des hydrogènes portés par les carbones est éventuellement substitué.

Il permet d'obtenir les polymères de l'invention sous leur forme réduite A.

Pour ce qui est des éventuels substituants des hydrogènes portés par les carbones acétyléniques du monomère halogéné, on peut utiliser les mêmes que ceux donnés précédemment lors de la définition des polymères selon l'invention. En ce qui concerne l'halogène Z on peut utiliser le chlore, le brome ou l'iode.

Comme métaux alcalins ou alcalino-terreux, utilisables, on peut citer le lithium, le sodium, le potassium, le béryllium, le magnésium, le calcium.

La réaction du lithium sur une amine d'acétylènes, comportant en opposition de la fonction $NH_2$ un hydrogène substitué par un halogène Z, est la suivante :

$$x\,NH_2-(-CH=CH-)_nZ + x\,Li \rightarrow -[-NH-(-CH=CH-)_n-]- + x\,LiZ + x/2\,H_2$$

L'action du métal alcalin ou alcalino-terreux sur le monomère substitué par un halogène est réalisée dans un solvant organique. Comme solvant, on peut citer le diméthylsulfoxyde (DMSO), le tétrahydrofurane (THF), l'hexaméthylphosphotriamine (HMPT), les éthers, dont l'éther éthylique.

Les polymères selon l'invention préparés selon ce second procédé présentent les mêmes propriétés électrochimiques que ceux obtenus par le premier procédé.

Les polymères selon l'invention peuvent être obtenus au moyen d'un troisième procédé de préparation.

Ce troisième procédé se caractérise en ce que l'on fait copolymériser par polycondensation dans un solvant aqueux ou non aqueux une diamine de formule $NH_2-(-CH=CH-)_nNH_2$ avec un dialdéhyde de formule $CHO-(-CH=CH-)_{n-1}CHO$, n étant un entier tel que $1 \leq n \leq 20$, formules dans lesquelles tout ou partie des hydrogènes portés par les carbones est éventuellement substitué.

Ce procédé permet d'obtenir les polymères selon l'invention sous leur forme oxydée B.

Les éventuels substituants des hydrogènes portés par les carbones acétyléniques de la diamine et du dialdéhyde utilisables sont ceux décrits précédemment lors de la définition des polymères selon l'invention.

La polycondensation selon l'invention d'une diamine et d'un dialdéhyde peut être symbolisée de la façon suivante :

$$NH_2-(-CH=CH-)_nNH_2 + CHO-(-CH=CH-)_{n-1}CHO \rightarrow$$

$$=N-(-CH=CH-)_nN=CH-(-CH=CH-)_{n-1}CH= +2H_2O$$

Il ressort de l'équation ci-dessus que la réaction d'un dialdéhyde sur une diamine se fait mole à mole.

Cette réaction est réalisée dans un solvant aqueux ou non comme par exemple l'eau, l'acétonitrile, l'acétone, un alcool tel que l'éthanol, le butanol, le propanol, ou un mélange eau-alcool.

Les polymères selon l'invention préparés selon ce troisième procédé présentent les mêmes propriétés électrochimiques que ceux obtenus par les précédents procédés.

Les polymères conducteurs directement obtenus par les trois procédés ci-dessus peuvent être modifiés afin de leur fixer au moins un reste oxydoréducteur et/ou photosensible suivant les applications envisagées pour ces polymères.

L'adjonction de ces restes peut être réalisée en effectuant, grâce à de l'acide nitrique fumant, une nitration partielle des polymères puis en réduisant le ou les groupements $NO_2$ formés en groupement $NH_2$ en présence d'étain et d'acide chlorhydrique. Ensuite, on fait réagir sur le ou les groupements $NH_2$ formés un chlorure d'acide de formule

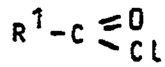

dans laquelle R¹ correspond au reste oxydoréducteur et/ou photosensible que l'on désire fixer sur les polymères. En particulier, R¹ représente un complexe d'un métal de transition tel que le ferrocène et les viologènes ou bien une quinone, une anthraquinone.

En ce qui concerne les polymères selon l'invention, dont tout ou partie des hydrogènes portés par les carbones de la chaîne acétylénique est substitué, ces polymères peuvent être obtenus soit en substituant l'un des deux hydrogènes ou les deux hydrogènes de l'une des fonctions acétyléniques du monomère correspondant, soit en substituant un ou plusieurs hydrogènes des polymères hydrogénés obtenus après polymérisation selon les trois procédés décrits précédemment. Cette dernière possibilité est réalisée de la même façon que pour la fixation d'un reste oxydoréducteur et/ou photosensible.

L'invention a aussi pour objet une cellule d'affichage électrochrome comportant, dans un récipient étanche transparent, une couche électrochrome baignant dans un électrolyte disposé entre une électrode de forme appropriée à l'affichage et une contreélectrode se caractérisant en ce que la couche électrochrome est un film mince d'un polymère selon l'invention, tel que décrit précédemment, recouvrant l'électrode.

Un avantage important des couches électrochromes formées de polymères conducteurs selon l'invention, par rapport aux cristaux liquides, réside dans l'existence d'un plus grand contraste sous un angle d'incidence élevé et donc d'une lecture plus facile. Par ailleurs, ces polymères sont très stables à l'inverse de certains cristaux liquides.

Comme électrolyte utilisable dans une cellule d'affichage selon l'invention, on peut citer des milieux acides riches en fluorures et en particulier l'eutectique $NH_3$, HF (bain N) ou bien des acides minéraux contenant un de leurs sels. On peut utiliser par exemple une solution d'acide chlorhydrique à pH 0 contenant 1 mol/l de NaCl ou de KCl, une solution d'acide sulfurique à pH 0 contenant 1 mol/l de $Na_2SO_4$, une solution d'acide tétrafluoroborique pH 0 contenant 1 mol/l de $NaBF_4$, ou une solution d'acide fluorosulfurique contenant 1 mol/l de $NaSO_3F$. Comme autre électrolyte utilisable, on peut encore citer une solution organique d'acétonitrile, de nitrométhane ou de benzonitrile contenant 1 mol/l de perchlorate de lithium, ou d'un polymère conducteur ionique tel que le polyoxyde d'éthylène (POE) ou de propylène, contenant du $LiClO_4$.

Compte tenu de l'agressivité de certains électrolytes et en particulier des milieux acides riches en fluorures (bain N notamment), il est préférable de déposer, par exemple par oxydation électrochimique, le film de polymère électrochrome selon l'invention sur un substrat de plastique transparent rendu superficiellement conducteur par un dépôt préalable d'une couche conductrice constituant l'électrode d'affichage. Ce substrat en plastique est lui-même déposé sur un support minéral rigide et transparent, tel que du verre, constituant les parois du récipient étanche.

Comme substrat en plastique, on peut citer les polyesters, les polycarbonates, le polypropylène, le téflon, les néoprènes, etc... L'épaisseur du film plastique peut varier de 5 µm à quelques mm.

Les électrodes et contre-électrodes peuvent être réalisées en l'un des matériaux choisis parmi l'or, le platine, le silicium, le nickel, l'oxyde d'indium et/ou d'étain. Leur épaisseur peut aller de 10 à 300 nm.

L'invention a encore pour objet un générateur électrochimique comportant, dans un récipient étanche un premier collecteur de courant recouvert d'une matière active positive, un second collecteur de courant recouvert d'une matière active négative, les matières actives baignant dans un électrolyte, caractérisé en ce que l'une des matières actives est formée d'une couche d'un polymère selon l'invention recouvrant l'électrode.

La couche peut être soit un film mince, soit une pastille comprimée, comportant du noir de carbone. La pastille de polymère peut être élaborée à partir d'une pâte visqueuse dudit polymère et de noir de carbone que l'on comprime.

Le film ou la pastille comprimée de polymère conducteur électronique selon l'invention constitue avantageusement la matière active positive d'électrode. Toutefois, les polymères de l'invention pourraient constituer la matière active négative d'électrode.

Lorsque les polymères selon l'invention constituent la matière active positive d'électrode, la matière active de l'électrode négative peut être constituée par un métal réactif tel que le lithium ou le zinc, par un alliage et en particulier de lithium et d'aluminium, par un polymère conjugué conducteur, par du carbone ou par un matériau composite. De préférence, on utilise un métal réactif tel que le lithium ou le zinc ainsi que les alliages de lithium-aluminium.

Les électrolytes associés aux électrodes ci-dessus sont de préférence des sels de lithium tels que le fluorure, le chlorure, le perchlorate, le perborate, le persulfate ou l'hexafluorophosphate. Néanmoins, on pourrait employer l'hexafluorophosphate de sodium, le fluoroborate de tétraméthylammonium, le chlorure de tétraméthylammonium, le fluorure de tétraméthylammonium ou de tétrabutylammonium.

Ces électrolytes sont en particulier dissous dans un solvant organique comme par exemple les éthers linéaires tels que le diméthoxyéthane, les éthers cycliques, le dioxolane ou les méthylhydrofuranes par exemple, ou des esters tels que le carbonate de propylène.

Lorsque l'on utilise comme solvant d'un électrolyte un milieu aqueux, il est recommandé d'utiliser des solutions dont le pH est inférieur à 5 avec des électrolytes divers. Comme solution on peut citer une solution d'acide sulfurique contenant du $Na_2SO_4$, une solution d'acide tétrafluoroborique contenant du $NaBF_4$, une solution d'acide phosphorique contenant du $Na_3PO_4$. En particulier, on peut employer comme électrolyte une solution d'acide chlorhydrique contenant 1 mol/l de chlorure de zinc, lorsque l'on utilise comme matière d'électrode négative du zinc.

L'un des avantages de réaliser la matière active négative ou positive d'électrode d'un générateur ou batterie électrochimique avec les polymères selon l'invention réside dans leur bonne capacité massique.

Dans le cas de la polyamine de vinyle (PVA) conformément à l'invention, la capacité massique du matériau, si l'on admet qu'un électron est échangé par motif $C_2H_2N$ avec les ions $H_3O^+$ et $F^-$ ou $ClO^-_4$ de l'électrolyte, est respectivement de 344 et 169 Ah/kg. Le même calcul pour la polyaniline donne respectivement 200 et 129 Ah/kg.

Etant donné que la capacité massique de la polyaniline est voisine de 150 Ah/kg, avec la polyamine de vinyle de l'invention, on peut avoir des capacités massiques voisines de 200 Ah/kg. Ceci constitue une amélioration considérable par rapport aux polymères conducteurs précédemment décrits.

D'autres caractéristiques et avantages de l'invention ressortiront mieux de la description qui va suivre, donnée à titre illustratif et non limitatif en référence aux figures annexées, dans lesquelles :

- la figure 1 représente, en coupe, un générateur électrochimique comportant une électrode chargée d'un polymère conducteur selon l'invention et
- la figure 2 représente, en coupe, une cellule d'affichage électrochromique comportant une couche électrochrome en polymère conducteur selon l'invention.

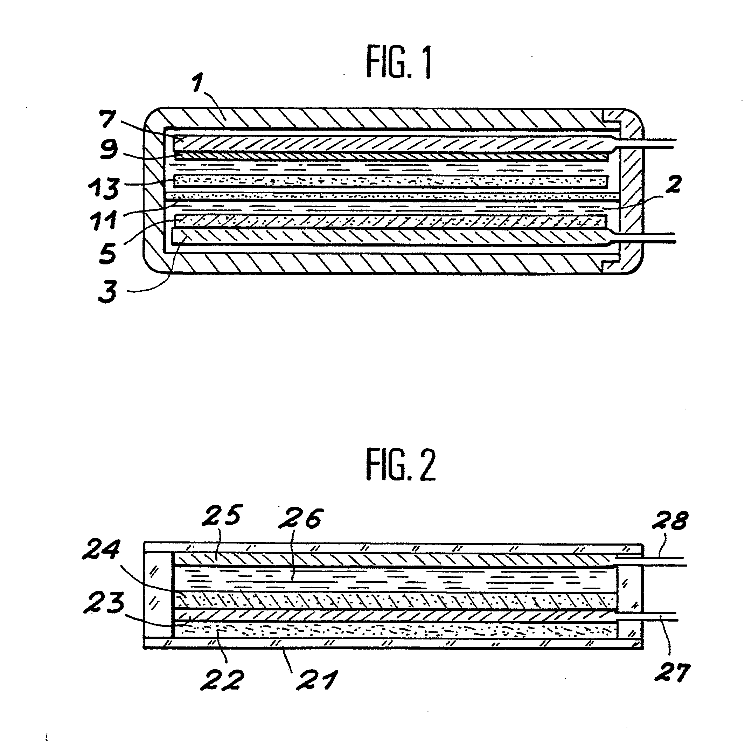

Sur la figure 1, on a représenté en coupe un mode de réalisation d'un générateur électrochimique ou batterie selon l'invention. Ce générateur comprend un boîtier 1 étanche et isolant, notamment en polyéthylène, contenant un électrolyte 2. Cet électrolyte est formé d'une solution molaire de perchlorate de lithium dissous dans du carbonate de propylène.

Dans cet électrolyte, sont placés un premier conducteur de courant 3 recouvert d'une matière active positive 5 et un collecteur 7 en contact avec une matière active négative 9. Ces collecteurs 3 et 7 se présentent sous forme de grilles ou de plaques.

Le premier collecteur 3 constitué d'une électrode de carbone est recouvert d'une couche de polyamine de vinyle (PVA) d'épaisseur 0,5 mm, déposée par oxydation électrochimique dans un "bain N" comme décrit précédemment, constituant la matière active positive. Le second collecteur 7 en acier inoxydable est recouvert, par exemple par électrolyse, d'une couche 9 de lithium ou d'un alliage de lithium-aluminium jouant le rôle de la matière active négative.

Des séparateurs 11 et 13 peuvent être prévus pour éviter tout court-circuit. En particulier, le séparateur 11 est constitué d'une membrane en Nafion 11(R) et le séparateur 13 d'un tissu en fibres minérales. Toutefois, d'autres membranes échangeuses d'ions, du téflon microporeux, des films cellulosiques, voire du papier spécialement traité à cet usage, de la laine de verre, des membranes en polymère et par exemple en polyéthylène ou polypropylène peuvent être utilisées en tant que séparateurs.

Selon l'invention, il est possible d'utiliser à la place de la couche de lithium 9 une couche de zinc. Dans ce cas, il sera préférable d'utiliser comme électrolyte une solution aqueuse de chlorure de zinc ayant un pH inférieur à 4, l'acidité étant due à de l'acide chlorhydrique.

Plusieurs générateurs ou batteries électrochimiques unitaires peuvent être utilisés, reliés entre eux en série ou en parallèle.

Sur la figure 2, on a représenté en coupe une cellule d'affichage électrochrome selon l'invention. Cette cellule comprend un récipient isolant transparent 21 par exemple en verre dans lequel se trouve enfermé un support plastique 22 de polyester recouvert d'une électrode 23, appropriée à l'affichage, formée en particulier dans une couche d'or mince d'environ 10 nm. A la surface de cette couche d'or 23 se trouve une couche 24 électrochrome de polyamine de vinyle d'environ 0,5 µm, préparée comme décrit précédemment par électropolymérisation dans un "bain N". Le récipient 21 renferme encore une contre-électrode 25 en platine et un électrolyte 26 formé par exemple d'une solution organique d'acétonitrile contenant 1 mol/l de perchlorate de lithium ou d'un "bain N". Les conducteurs 27 et 28 permettent d'alimenter en courant électrique la cellule électrochrome et de faire varier le degré d'oxydation ou de réduction de la couche électrochrome en polymère afin d'en changer sa coloration.

Les applications des polymères conducteurs selon l'invention données ci-dessus n'ont bien entendu été données qu'à titre illustratif, beaucoup d'autres applications pouvant être envisagées comme on l'a vu précédemment.

On va maintenant donner à titre d'exemple quelques procédés de préparation de polymères conducteurs selon l'invention, utilisables en particulier comme masse positive d'électrode dans un générateur électrochimique tel que décrit précédemment.

EXEMPLE 1

On prépare tout d'abord 100 $cm^3$ de "bain N" contenant 54,2% de HF libre et 80,9% de HF total en poids que l'on sature par barbotage de vinylamine. Tout en agitant fortement ce bain, on ajoute lentement 5 g de bichromate de potassium par petites fractions, pendant 5 minutes. On laisse agir pendant 30 minutes environ sous agitation. Le mélange obtenu est alors dilué à l'eau, filtré, lavé à l'eau puis à l'acétonitrile, et enfin séché à 25°C. On récupère alors 2,3 g d'une poudre noire de polynitrénium d'acétylène (forme C), les anions étant constitués des ions $F^-$ du "bain N".

Cette poudre peut être utilisée comme masse active positive d'une batterie ayant un potentiel de 2,8 V par rapport à une matière d'électrode négative de lithium-aluminium.

EXEMPLE 2

Dans le même "bain N" que celui de l'exemple 1, on a dissous par barbotage 5 ml d'hexatriènamine (n=3). Après avoir comme dans l'exemple 1 ajouté 5 g de bichromate de potassium, laissé agir, lavé, filtré et séché le mélange obtenu, on a récupéré 3,0 g d'une poudre de polynitrénium d'hexatriène (forme C).

Cette poudre peut aussi être utilisée comme masse active positive de batterie. Elle présente un potentiel de 3,1 V par rapport à une matière d'électrode négative de lithium-aluminium.

EXEMPLE 3

Sur une électrode de carbone, on a déposé électrochimiquement un film de polyamine de vinyle (forme C) d'environ 100 µm d'épaisseur.

Ce film a été obtenu dans un réacteur dans lequel on avait introduit 50 $cm^3$ de "bain N" saturé en vinylamine par barbotage. Dans le bain obtenu, on a placé une électrode en carbone de 40 $cm^2$ en face d'une électrode de nickel et on a appliqué un courant constant de 1 mA/$cm^2$ pendant une heure. L'anode en carbone est devenue noir intense par suite du dépôt de 75 mg de polyamine de vinyle. Le dépôt obtenu a ensuite été lavé à l'eau, à l'acétone, puis au carbonate de propylène et séché à 25°C. Le dépôt ainsi obtenu peut être utilisé directement comme masse active positive d'une batterie.

EXEMPLE 4

De la même façon que dans l'exemple 3, on a déposé électrochimiquement un film de polyamine d'hexatriène (forme C) d'environ 100 µm d'épaisseur sur une électrode en carbone. Ce film a été obtenu dans les mêmes conditions que dans l'exemple 3 avec 50 $cm^3$ de "bain N" additionné de 0,5 $cm^3$ d'hexatriènamine Le dépôt obtenu de 81 mg de polyamine d'hexatriène, après lavage, filtrage et séchage, comme dans l'exemple 3, peut être directement utilisé comme masse active positive de batterie.

EXEMPLE 5

Dans 100 $cm^3$ de tétrahydrofurane (THF), on fait agir 2 g de lithium sur 10 g d'un dérivé monobromé de la vinylamine de formule $Br\text{-}CH{=}CH\text{-}NH_2$ pendant 30 minutes. Après lavage à l'eau, filtrage, lavage à l'acétonitrile et séchage, on obtient 1,5 g de polyamine de vinyle (forme A).

EXEMPLE 6

De la même façon que dans l'exemple 5, on fait agir dans 100 $cm^3$ de THF 2 g de lithium sur 8 g d'un dérivé monobromé de l'hexatrièlamine. On obtient 2,1 g de polyamine d'hexatriène (forme A) après lavage, filtrage et séchage.

EXEMPLE 7

Dans 100 $cm^3$ d'acétonitrile, on fait agir 1 g de diamino-1,2 éthylène avec 2 $cm^3$ d'une solution de glyoxal à 40% en volume dans l'eau. On obtient un précipité qu'on lave à l'eau, filtre, lave à l'acétonitrile puis sèche à 25°C. Il en résulte 1,5 g d'une poudre de polyimine d'acétylène (forme B).

**Revendications**

1. Polymère conducteur électronique azoté, caractérisé en ce qu'il présente sous forme réduite A la formule :

$$-[-NH-(-CH{=}CH-)_n-]_x \quad ,$$

sous une première forme oxydée B la formule:

$$-[-N=(=CH-CH=)=_nN-(-CH=CH-)-_n]-_y \quad ,$$

et sous une seconde forme oxydée C la formule:

$$-[-\overset{\oplus}{N}-(-CH=CH-)-_n-]-_xX^-,$$

formules dans lesquelles n, x et y sont des entiers tels que $1 \leq n \leq 20$, $10 \leq x \leq 1\ 000\ 000$ et $5 \leq y \leq 500\ 000$, $X^-$ représente un anion simple ou complexe et dans lesquelles tout ou partie des hydrogènes portés par les carbones est éventuellement substitué.

2. Polymère selon la revendication 1, caractérisé en ce que des hydrogènes portés par les carbones du polymère sont substitués par un halogène, un radical alkyle, linéaire ou ramifié ou un radical aryle éventuellement substitué, un groupement choisi parmi :

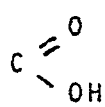 , 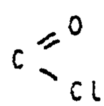 , 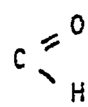 , 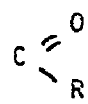 , 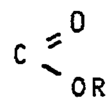 , 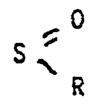 , 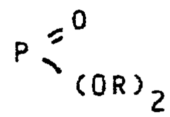 , $SO_2R$

SR, OR, avec R un radical alkyle, linéaire ou ramifié, ou un radical aryle, éventuellement substitué, et parmi OH, $NO_2$, $NH_2$, $CF_3$, $SO_2$, CN, SCN, OCN.

3. Polymère selon la revendication 1 ou 2, caractérisé en ce qu'il comporte un reste oxydo-réducteur et/ou photosensible.

4. Polymère selon la revendication 1, caractérisé en ce qu'il présente sous forme réduite A la formule :

$$-[-NH-CH=CH-]-_x\ ,$$

sous la première forme oxydée b la formule :

$$-[-N=CH-CH=N-CH=CH-]-_{x/2}\ ,$$

et sous la seconde forme oxydée C la formule :

$$-(-\overset{\oplus}{N}-CH=CH-)-_x\ X^-.$$

5. Polymère selon la revendication 1, caractérisé en ce qu'il présente sous forme réduite A la formule :

$$-[-NH-CH=CH-CH=CH-]-_x\ ,$$

sous la première forme oxydée B la formule :

$$-[-N=CH-CH=CH-CH=N-CH=CH-CH=CH-]-_{x/2}\ ,$$

et sous la seconde forme oxydée C la formule :

$$-[-\overset{\oplus}{N}-CH=CH-CH=CH-]-_x\ X^-.$$

6. Polymère selon la revendication 1, caractérisé en ce qu'il présente sous forme réduite A la formule :

$$-[-NH-CH=CH-CH=CH-CH=CH-]-_x\ ,$$

sous la première forme oxydée B la formule :

$$-[-N=CH-CH=CH-CH=CH-CH=N-CH=CH-CH=CH-CH=CH-]-_{X/2}$$

et sous la troisième forme oxydée C la formule :

$$-[-\overset{\oplus}{N}-CH=CH-CH=CH-CH=CH-]-_x\ X^-.$$

7. Polymère selon l'une quelconque des revendications 1 à 6, caractérisé en ce que $X^-$ est choisi parmi $Cl^-$, $HSO^-_4$, $BF^-_4$, $SO_3F^-$, $BR^-$, $F^-$, $I^-$, $ClO^-_4$, $H_2PO^-_4$, $SO_4^{2-}$, $PF^-_6$, $S^{2-}$, $(S_p)^{2-}$ avec $1 < p \leq 10$ et des polyanions.

8. Polymère selon l'une quelconque des revendications 3 à 7, caractérisé en ce que le reste oxyréducteur et/ou photosensible est choisi parmi un complexe d'un métal de transition, une quinone ou ses dérivés, une anthraquinone et ses dérivés.

9. Procédé de préparation d'un polymère conducteur électronique azoté, caractérisé en ce que l'on oxyde en milieu liquide un monomère de formule $NH_2-(-CH=CH-)_n-H$, n étant un entier tel que $1 \leq n \leq 20$, formule dans laquelle tout ou partie des hydrogènes portés par les carbones est éventuellement substitué.

10. Procédé selon la revendication 9, caractérisé en ce que pour n=1, on forme le monomère par oxydation en milieu liquide de l'éthylamine ou de ses dérivés.

11. Procédé selon la revendication 9 ou 10, caractérisé en ce que le milieu liquide est un milieu acide riche en fluorures.

12. Procédé selon l'une quelconque des revendications 9 à 11, caractérisé en ce que l'oxydation est réalisée chimiquement ou électrochimiquement.

13. Procédé de préparation d'un polymère conducteur électronique azoté, caractérisé en ce que l'on fait réagir dans un solvant organique un métal alcalin ou alcalino-terreux sur un composé de formule $NH_2-(-CH=CH-)_n-Z$, n étant un entier tel que $1 \leq n \leq 20$ et Z étant un halogène, formule dans laquelle tout ou partie des hydrogènes portés par les carbones est éventuellement substitué.

14. Procédé selon la revendication 13, caractérisé en ce que le solvant est choisi parmi le diméthylsulfoxyde, le tétrahydrofurane, l'hexaméthylphosphotriamine, l'éther éthylique.

15. Procédé de fabrication d'un polymère conducteur électronique azoté, caractérisé en ce que l'on fait copolymériser par polycondensation dans un solvant aqueux ou non aqueux une diamine de formule $NH_2-(-CH=CH-)_n-NH_2$ avec un dialdéhyde de formule $CHO-(-CH=CH-)_{n-1}-CHO$, n étant un entier tel que $1 \leq n \leq 20$, formules dans lesquelles tout ou partie des hydrogènes portés par les carbones est éventuellement substitué.

16. Procédé selon l'une quelconque des revendications 9 à 15, caractérisé en ce que les hydrogènes portés par les carbones sont substitués par un halogène, un radical alkyle, linéaire ou ramifié, ou un radical aryle, éventuellement substitué, un groupement choisi parmi :

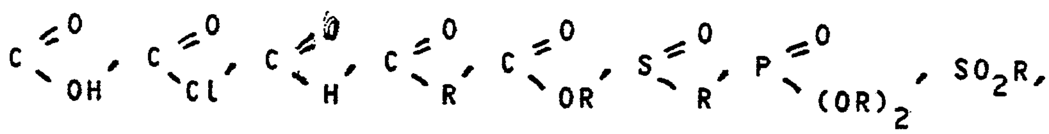

SR, OR, avec R un radical alkyle, linéaire ou ramifié, ou un radical aryle, éventuellement substitué, et parmi OH, $NO_2$, $NH_2$, $CF_3$, $SO_2$, CN, SCN, OCN.

17. Procédé selon l'une quelconque des revendications 9 à 16, caractérisé en ce que l'on fixe un reste oxydoréducteur et/ou photosensible après polymérisation.

18. Utilisation du polymère conducteur selon l'une quelconque des revendications 1 à 8 comme couche électrochrome (24) ou comme matière active (5, 9) d'électrode dans un dispositif électrochimique.

19. Utilisation du polymère selon la revendication 18 comme matière active d'électrode dans un générateur électrochimique comportant dans un récipient étanche (1) une matière active positive (5) d'électrode et une matière active négative (9) d'électrode baignant dans un électrolyte (2), caractérisée en ce que le polymère se présente sous la forme d'un film mince.

20. Utilisation du polymère selon la revendication 18, comme matière active d'électrode dans un générateur électrochimique comportant dans un récipient étanche (1) une matière active positive (5) d'électrode et une matière active négative (9) d'électrode baignant dans un électrolyte (2), caractérisée en ce que le polymère se présente sous la forme d'une pastille comprimée, comportant du noir de carbone.

21. Utilisation du polymère selon l'une quelconque des revendications 18 à 20, comme matière active positive (5).

22. Utilisation du polymère selon la revendication 21 dans un générateur comportant comme matière active négative (9) une couche de lithium ou un alliage de lithium et d'aluminium et comme électrolyte (2) du perchlorate de lithium dissous dans du carbonate de propylène.

23. Utilisation du polymère selon la revendication 21 dans un générateur comportant comme matière active négative (9) une couche de zinc et comme électrolyte (2) une solution aqueuse de chlorure de zinc.

**Claims**

1. Nitrogenized electronic conductive polymer, characterized in that in the reduced form A it has the formula:

$$-[-NH-(-CH=CH-)_n-]_x$$

in a first oxidized form B the formula:

$$-[-N-(-CH-CH-)_n N-(-CH=CH-)_n-]_y$$

and in a second oxidized form C the formula:

$$-[-\overset{\oplus}{N}-(-CH=CH-)_n-]_x\ X^-,$$

in which n, x and y are integers such that $1 \leq n \leq 20$, $10 \leq x \leq 1\ 000\ 000$ and $5 \leq y \leq 500\ 000$, $X^-$ represents a simple or complex anion and in which all or part of the hydrogens carried by the carbons of the polymer are optionally sustituted.

2. Polymer according to claim 1, characterized in that hydrogens carried by the carbons of the polymer are substituted wholly or partly by a halogen, a straight-chained or branched alkyl radical, or an optionally substituted aryl radical, a group chosen from among:

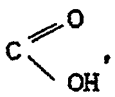 , 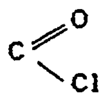 , 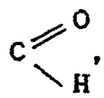 , 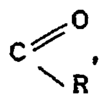 , 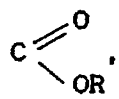 , 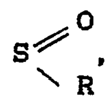 , 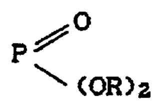 , $SO_2R$

SR, OR, with R a straight-chained or branched alkyl radical, or an optionally substituted aryl radical and from among OH, $NO_2$, $NH_2$, $CF_3$, $SO_2$, CN, SCN, OCN.

3. Polymer according to claims 1 or 2, characterized in that it comprises an oxidation reduction and/or photosensitive radical.

4. Polymer according to claim 1, characterized in that in the reduced form A it has the formula:

$$-[-NH-CH=CH-]_x$$

in the first oxidized form B the formula:

$$-[-N=CH-CH=N-CH=CH-]_{x/2}$$

and in the second oxidized form C the formula:

$$-(-\overset{\oplus}{N}-CH=CH-)_x\ X^-.$$

5. Polymer according to claim 1, characterized in that in the reduced form A it has the formula:

$$-[-NH-CH=CH-CH=CH-]_x$$

in the first oxidized form B the formula:

$$-[-N=CH-CH=CH-CH=N-CH=CH-CH=CH-]_{x/2}$$

and in the second oxidized form C the formula:

$$-[-\overset{\oplus}{N}-CH=CH-CH=CH-]_x\ X^-.$$

6. Polymer according to claim 1, characterized in that in the reduced form A it has the formula:

$$-[-NH-CH=CH-CH=CH-CH=CH-]_x$$

in the first oxidized form B the formula:

$$-[-N=CH-CH=CH-CH=CH-CH=N-CH=CH-CH=CH-CH=CH-]_{x/2}$$

and in the third oxidized form C the formula:

$$-[-\overset{\oplus}{N}-CH=CH-CH=CH-CH=CH-]_x\ X^-.$$

7. Polymer according to any one of the claims 1 to 6, characterized in that $X^-$ is chosen from among $Cl^-$, $HSO^-_4$, $BF^-_4$, $SO_3F^-$, $Br^-$, $F^-$, $I^-$, $ClO^-_4$, $H_2PO^-_4$, $SO_4{}^2$, $PF^-_6$, $S^{2-}$, $(S_p)^{2-}$ with $1 \leq p \leq 10$ and polyanions.

8. Polymer according to any one of the claims 3 to 7, characterized in that the oxidation reduction and/or photosensitive radical is chosen from among a transition metal complex, a quinone or its derivatives, an anthraquinone and its derivatives.

9. Process for the preparation of a nitrogenized electronic conductive polymer, characterized in that oxidation takes place in a liquid medium of a monomer of formula $NH_2-(-CH=CH-)_n-H$, n being an integer such as $1 \leq n \leq 20$, in which all or part of the hydrogens carried by the carbons are optionally substituted.

10. Process according to claim 9, characterized in that for n=1, the monomer is formed by oxydation in a liquid medium of ethylamine or its derivatives.

11. Process according to claims 9 or 10, characterized in that the liquid medium is a fluoride-rich acid medium.

12. Process according to any one of the claims 9 to 11, characterized in that oxidation is performed chemically or electrochemically.

13. Process for the preparation of a nitrogenized electronic conductive polymer, characterized in that in an organic solvent is reacted an alkaline earth or alkali metal on a compound of formula $NH_2-(-CH=CH-)_n-Z$, n being an integer such that $1 \leq n \leq 20$ and Z is a halogen, in which all or part of the hydrogens carried by the carbons are optionally substituted.

14. Process according to claim 13, characterized in that the solvent is chosen from among dimethylsulphoxide, tetrahydrofurane, hexamethylphosphotriamine and ethyl ether.

15. Process for the preparation of a nitrogenized electronic conductive polymer, characterized in that copolymerization takes place by polycondensation in an aqueous or non-aqueous solvent of a diamine of formula $NH_2-(-CH=CH-)_n-NH_2$ with a dialdehyde of formula $CHO-(-CH)CH-)_{n-1}-CHO$, n being an integer such that $1 \leq n \leq 20$, in which all or part of the hydrogens carried by the carbons are optionally substituted.

16. Process according to any one of the claims 9 to 15, characterized in that the hydrogens carried by the carbons are substituted by a halogen, a straight-chained or branched alkyl radical or an optionally substituted aryl radical, a group chosen from among:

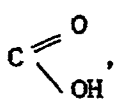, 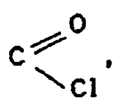, 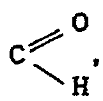, 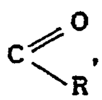, 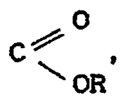, 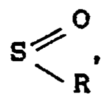, 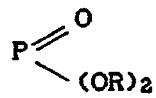, $SO_2R$,

SR, OR, with R being a straight-chained or branched alkyl radical, or an optionally substituted aryl radical and from among OH, $NO_2$, $NH_2$, $CF_3$, $SO_2$, CN, SCN, OCN.

17. Process according to any one of the claims 9 to 16, characterized in that an oxidation reduction and/or photosensitive radical is fixed after polymerization.

18. Use of the conductive polymer according to any one of the claims 1 to 8 as an electrochromic layer (24) or active electrode material (5, 9) in an electrochemical device.

19. Use of the polymer according to claim 18 as the active electrode material in an electrochemical generator having in a tight container (1) a positive electrode active material (5) and a negative electrode active material (9) immersed in an electrolyte (2), characterized in that the polymer is in thin film form.

20. Use of the polymer according to claim 18 as the active electrode material in an electrochemical generator having in a tight container (1) a positive electrode active material (5) and negative electrode active material (9) immersed in an electrolyte (2), characterized in that the polymer is in the form of a compressed pellet containing carbon black.

21. Use of the polymer according to one of the claims 18 to 20 as the positive active material (5).

22. Use of the polymer according to claim 21 in a generator in which the negative active material (9) is formed from a lithium or lithium-aluminium alloy layer and the electrolyte (2) by lithium perchlorate dissolved in propylene carbonate.

23. Use of the polymer according to claim 21 in a generator in which the negative active material (9) is formed from a zinc layer and the electrolyte (2) from an aqueous zinc chloride solution.

**Patentansprüche**

1. Elektronenleitendes stickstoffhaltiges Polymer, dadurch gekennzeichnet, daß es vorliegt in einer reduzierten Form A der Formel

$$-[-NH-(-CH=CH-)_n-]_x,$$

in einer ersten oxidierten Form B der Formel

$$-[-N{=}(=CH-CH=)_n{=}N-(-CH=CH-)_n]_y-$$

und in einer zweiten oxidierten Form C der Formel

$$-[-\overset{\oplus}{N}-(-CH=CH-)_n]_x- X^-,$$

wobei in den obengenannten Formeln bedeuten:
n, x und y solche ganze Zahlen, daß $1 \leq n \leq 20$; $10 \leq x \leq 1\,000\,000$ und $5 \leq y \leq 500\,000$,
$X^-$ ein einfaches oder ein komplexes Anion, und
daß in den Formeln die Wasserstoffatome an den Kohlenstoffatomen gegebenenfalls teilweise oder vollständig substituiert sind.

2. Polymer nach Anspruch 1, dadurch gekennzeichnet, daß die Wasserstoffatome an den Kohlenstoffatomen des Polymers teilweise oder vollständig substituiert sind durch ein Halogenatom, einen linearen oder verzweigten Alkylrest oder einen gegebenenfalls substituierten Arylrest, eine Gruppe, ausgewählt aus

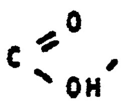, 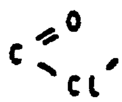, 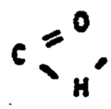, 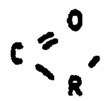, 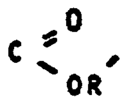, 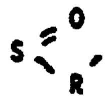, 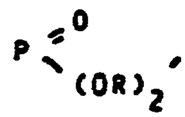, $SO_2R_1$

SR, OR, worin R einen linearen oder verzweigten Alkylrest oder einen gegebenenfalls substituierten Arylrest darstellt, und aus OH, $NO_2$, $NH_2$, $CF_3$, $SO_2$, CN, SCN und OCN.

3. Polymer nach Anspruch 1 oder 2, dadurch gekennzeichnet, daß es einen Oxidoreduktions- und/oder lichtempfindlichen Rest aufweist.

4. Polymer nach Anspruch 1, dadurch gekennzeichnet, daß es vorliegt
in der reduzierten Form A der Formel

$$-[-NH-CH=CH-]_x-,$$

in der ersten oxidierten Form B der Formel

$$-[-N=CH-CH=N-CH=CH-]_{x/2}-$$

und in der zweiten oxidierten Form C der Formel

$$-(-\overset{\oplus}{N}-CH=CH-)_x- X^-.$$

5. Polymer nach Anspruch 1, dadurch gekennzeichnet, daß es vorliegt
in der reduzierten Form A der Formel

$$-[-NH-CH=CH-CH=CH-]_x-,$$

in der ersten oxidierten Form B der Formel

$$-[-N=CH-CH=CH-CH=N-CH=CH-CH=CH-]_{x/2}-$$

und in der zweiten oxidierten Form C der Formel

$$-[-\overset{\oplus}{N}-CH=CH-CH=CH-]_x- X^-.$$

6. Polymer nach Anspruch 1, dadurch gekennzeichnet, daß es vorliegt
in der reduzierten Form A der Formel

$$-[-NH-CH=CH-CH=CH-CH=CH-]_x-,$$

in der ersten oxidierten Form B der Formel

$$-[-N=CH-CH=CH-CH=CH-CH=N-CH=CH-CH=CH-CH=CH-]_{x/2}-$$ und

in der dritten oxidierten Form C der Formel

$$-[-\overset{\oplus}{N}-CH=CH-CH=CH-CH=CH-]-_x X^-.$$

7. Polymer nach einem der Ansprüche 1 bis 6, dadurch gekennzeichnet, daß $X^-$ ausgewählt wird aus $Cl^-$, $HSO^-_4$, $BF^-_4$, $SO_3F^-$, $BR^-$, $F^-$, $J^-$, $ClO^-_4$, $H_2PO^-_4$, $SO_4^{2-}$, $PF^-_6$, $S^{2-}$, $(S_p)^{2-}$ mit $1 \leq p \leq 10$ und Polyanionen.

8. Polymer nach einem der Ansprüche 3 bis 7, dadurch gekennzeichnet, daß der Oxidoreduktions- und/oder lichtempfindliche Rest ausgewählt wird aus einem Komplex eines Übergangsmetalls, einem Chinon oder seinen Derivaten, einem Anthrachinon und seinen Derivaten.

9. Verfahren zur Herstellung eines elektronenleitenden stickstoffhaltigen Polymers, dadurch gekennzeichnet, daß man in flüssigem Milieu ein Monomer der Formel

$$NH_2-(-CH=CH-)-_n-H$$

worin n eine solche ganze Zahl ist, daß $1 \leq n \leq 20$ und worin die Wasserstoffatome an den Kohlenstoffatomen gegebenenfalls vollständig oder teilweise substituiert sind, oxidiert.

10. Verfahren nach Anspruch 9, dadurch gekennzeichnet, daß für n = 1 das Monomere gebildet wird durch Oxidation von Ethylamin oder seinen Derivaten in flüssigem Milieu.

11. Verfahren nach Anspruch 9 oder 10, dadurch gekennzeichnet, daß es sich bei dem flüssigen Milieu um ein Fluorid-reiches Säuremilieu handelt.

12. Verfahren nach einem der Ansprüche 9 nbis 11, dadurch gekennzeichnet, daß die Oxidation chemisch oder elektrochemisch durchgeführt wird.

13. Verfahren zur Herstellung eines elektronenleitenden stickstoffhaltigen Polymers, dadurch gekennzeichnet, daß man in einem organischen Lösungsmittel ein Alkalimetall oder Erdalkalimetall mit einer Verbindung der Formel reagieren läßt

$$NH_2-(-CH=CH-)-_n-Z$$

worin n eine solche ganze Zahl bedeutet, daß $\leq n \leq 20$ und Z ein Halogenatom darstellt, und in der die Wasserstoffatome an den Kohlenstoffatomen gegebenenfalls vollständig oder teilweise substituiert sind.

14. Verfahren nach Anspruch 13, dadurch gekennzeichnet, daß das Lösungsmittel ausgewählt wird aus Dimethylsulfoxid, Tetrahydrofuran, Hexamethylphosphortriamin und Ethyläther.

15. Verfahren zur Herstellung eines elektronenleitenden stickstoffhaltigen Polymers, dadurch gekennzeichnet, daß man in einem wäßrigen oder nicht-wäßrigen Lösungsmittel durch Polykondensation copolymerisieren läßt ein Diamin der Formel $NH_2-(-CH=CH-)-_nNH_2$ mit einem Dialdehyd der Formel $CHO-(-CH=CH-)-_{n-1}CHO$, wobei in diesen Formeln n eine solche ganze Zahl bedeutet, daß $1 \leq n \leq 20$ und die Wasserstoffatome an den Kohlenstoffatomen gegebenenfalls vollständig oder teilweise substituiert sind.

16. Verfahren nach einem der Ansprüche 9 bis 15, dadurch gekennzeichnet, daß die Wasserstoffatome an den Kohlenstoffatomen substituiert sind durch ein Halogenatom, einen linearen oder verzweigten Alkylrest oder einen gegebenenfalls substituierten Arylrest, eine Gruppe, ausgewählt aus

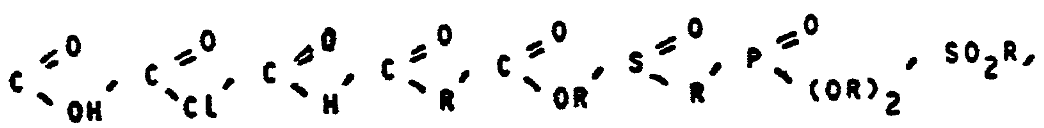

SR, OR mit R = ein linearer oder verzweigter Alkylrest oder ein gegebenenfalls substituierter Arylrest, und aus OH, $NO_2$, $NH_2$, $CF_3$, $SO_2$, CN, SCN und OCN.

17. Verfahren nach einem der Ansprüche 9 bis 16, dadurch gekennzeichnet, daß man einen Oxidoreduktions- und/oder lichtempfindlichen Rest nach der Polymerisation fixiert.

18. Verwendung des elektrisch leitenden Polymers nach einem der Ansprüche 1 bis 8 als elektrochrome Schicht (24) oder als aktives Elektrodenmaterial (5, 9) in einer elektrochemischen Vorrichtung.

19. Verwendung des Polymers nach Anspruch 18 als aktives Elektrodenmaterial in einem elektrochemischen Generator, der in einem dichten Behälter (1) ein positives aktives Elektrodenmaterial (5) und ein negatives aktives Elektrodenmaterial (9) aufweist, das in einen Elektrolyten (2) eintaucht, dadurch gekennzeichnet, daß das Polymer in Form eines dünnen Films vorliegt.

20. Verwendung des Polymers nach Anspruch 18 als aktives Elektrodenmaterial in einem elektrochemischen Generator, der in einem dichten Behälter (1) ein positives aktives Elektrodenmaterial (5) und ein negatives aktives Elektrodenmaterial (9) aufweist, das in einen Elektrolyten (2) eintaucht, dadurch gekennzeichnet, daß das Polymer in Form einer Tablette vorliegt, die Ruß enthält.

21. Verwendung des Polymers nach einem der Ansprüche 18 bis 20 als aktives positives Material (5).

22. Verwendung des Polymers nach Anspruch 21 in einem Generator, der als aktives negatives Material (9) eine Schicht aus Lithium oder einer Lithium-Aluminium-Legierung und als Elektrolyt (2) Lithiumperchlorat, gelöst in Propylencarbonat, aufweist.

23. Verwendung des Polymers nach Anspruch 21 in einem Generator, der als aktives negatives Material (9) eine Schicht aus Zink und als Elektrolyt (2) eine wäßrige Zinkchloridlösung aufweist.

FIG. 1

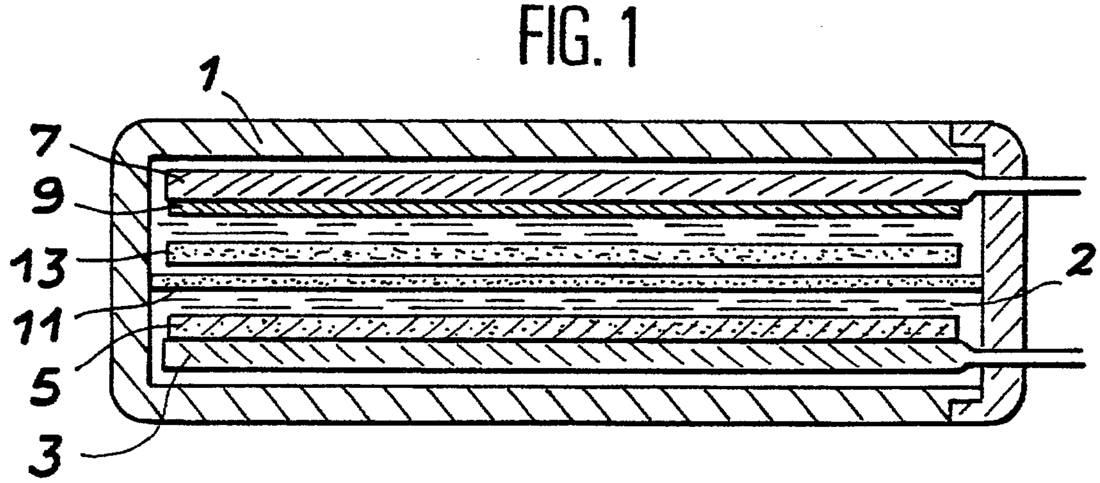


FIG. 2